# EUROPEAN PATENT SPECIFICATION

(11) **EP 4 489 302 B1**
(45) Date of publication and mention of the grant of the patent: **25.02.2026**
(21) Application number: 23386056.8
(22) Date of filing: 06.07.2023
(51) Int. Cl.: H03F 3/60, H03F 3/195, H03F 3/21, H03F 3/213, H03F 3/24

(54) **SINGLE POLE MULTIPLE THROW POWER AMPLIFIER MODULE**
EINPOLIGES LEISTUNGSVERSTÄRKERMODUL MIT MEHREREN REICHWEITEN
MODULE AMPLIFICATEUR DE PUISSANCE UNIPOLAIRE MULTIDIRECTIONNEL

(43) Date of publication of application: 08.01.2025
(73) Proprietor: Circuits Integrated Hellas SA, 14562 Kifisia (GR)
(72) Inventor: Fioravanti, Paolo, 14562 Kifisia (GR); Lourandakis, Errikos, 14562 Kifisia (GR); Gurulian, Alexandros, 14562 Kifisia (GR); Bampali, Pagona, 14562 Kifisia (GR)
(74) Representative: D Young & Co LLP

(56) References cited:
- EP-A1- 1 630 570
- US-A1- 2023 140 451
- ROBERG MICHAEL ET AL: "40 W Ka-Band Single and Dual Output GaN MMIC Power Amplifiers on SiC", 2018 IEEE BICMOS AND COMPOUND SEMICONDUCTOR INTEGRATED CIRCUITS AND TECHNOLOGY SYMPOSIUM (BCICTS), IEEE, 15 October 2018 (2018-10-15), pages 140 - 143, XP033458235, [retrieved on 20181127], DOI: 10.1109/BCICTS.2018.8551075

## Description

### Field of the Invention

The present invention relates to power amplifier modules, in particular single-input multiple-output power radio-frequency amplifier modules.

### Background

Power amplifier modules, in particular radio-frequency (RF) power amplifier modules, are widespread and have a number of different applications. These include, for example, driving a transmitting antenna or a microwave cavity resonator. A number of different approaches for power amplifier modules for these use cases, and more, have been implemented, including multipath power amplifiers, where several unit amplifiers are driven in parallel by a single RF source.

In some use cases, it is desirable to have a power amplifier module that is capable of delivering power to a particular output port, while other outputs ports must remain isolated. However, in many cases the isolation between output ports is not sufficient at high power levels or at particular RF frequency ranges.

Accordingly, there exists a desire to increase isolation levels between output ports for power amplifiers to be implemented in a number of use cases.

US 2023/140451 A1 relates to amplifier device packages incorporating internal couplers.

EP 1 630 570 A1 relates to a transceiver module for a system of two phased array antennas.

Michael, R., "40W Ka-Band Single and Dual Output GaN MMIC Power Amplifiers of SiC", 2018 IEEE BCICTS, October 2018, pages 140-143, relates to a dual output PA integrated with an input SPDT switch and output isolation circuitry.

### Summary of the Disclosure

The present invention can help address or mitigate at least some of the issues discussed above. The invention is defined by the appended claims.

According to a first example implementation there is provided circuitry for a single-input multiple-output multi-path power amplifier, the circuitry comprising: dividing circuitry configured to receive a single input signal and provide a plurality of split signals having different phases to each of a plurality of circuitry branches, wherein a phase of each of the split signals provided to the circuitry branches is determined by a configuration of the dividing circuitry, the dividing circuitry having a plurality of possible configurations, and wherein a number of circuitry branches corresponds to a number of possible configurations of the dividing circuitry; amplification circuitry arranged in each of the plurality of circuitry branches and configured to receive the plurality of split signals on the respective circuitry branch, wherein the amplification circuitry is configured to amplify the plurality of split signals to provide a plurality of amplified signals; combiner circuitry configured to receive the plurality of amplified signals from each of the plurality of circuitry branches and provide a single output signal to one of a plurality of output terminals, wherein a number of output terminals corresponds to the number of possible configurations of the dividing circuitry, and wherein the single output signal is provided to a particular one of the plurality of output terminals according to the configuration of the dividing circuitry.

In particular, rather than relying on a single switch located at the output of the signal chain to provide isolation between output ports, or using complex dedicated isolation circuitry, the circuitry disclosed herein balances the phase and amplitude relationships between multiple circuitry branches, and locates the switching circuitry at the beginning of the signal chain, in order to achieve isolation levels not otherwise possible at mm-wave frequencies with minimum loss of efficiency.

The dividing circuitry comprises: switching circuity configured to receive the single input signal and provide a plurality of switched signals having different phases to the plurality of circuitry branches, wherein the phase of each of the plurality of switched signals provided to the respective circuitry branches is determined by a configuration of the switching circuitry, the switching circuitry having the plurality of possible configurations, and wherein the number of circuitry branches corresponds to a number of possible configurations of the switching circuitry; and splitting circuitry arranged in each of the plurality of circuitry branches and configured to receive a respective switched signal and provide the plurality of split signals on the respective circuitry branch. As such, a Butler matrix providing the required number of signals with the required number of phases based on a single input signal may be implemented.

In some examples, the switching circuitry comprises: a single pole double throw (SPDT) switch having two possible configurations, and a hybrid coupler, wherein the SPDT switch is configured to provide a single signal to the hybrid coupler, and wherein the hybrid coupler is configured to provide an in-phase signal to either a first or second circuitry branch of the plurality of circuitry branches and provide a quadrature signal to the other of the first or second circuitry branches according to the configuration of the SPDT switch; wherein the plurality of output terminals comprise two output terminals. As such, a PA module which provides two switchable output terminals having high levels of isolation therebetween is provided.

In some examples, the switching circuitry comprises: active elements such as amplifiers or transconductors sharing the same input, which are selectively operated to provide a single signal to the hybrid coupler, thereby providing an alternative form of switching circuitry to a SPDT switch and hybrid coupler combination. As such, a PA module which provides two switchable output terminals having high levels of isolation therebetween is provided.

In some examples, each of the plurality of circuitry branches includes two or more paths, each of the two or more paths configured to receive a particular one of the plurality of split signals and each of the two or more paths including the amplification circuitry. Accordingly, a multi-path power amplifier module is provided, thereby increasing the overall power of the PA module, while providing high levels of isolation between output terminals of the PA module. Moreover, the output impedance of the PA module changes based on the output power, as the impedance of the amplifying elements delivering power changes with power level. As such, the use of multiple paths on a circuitry branch is useful to desensitize the output port impedance from the variation of the output impedance of the power providing amplifying elements. For example by combining the power of such elements with a Hybrid combiner with a terminated isolation port, maintaining and possibly further increasing the isolation between the output ports.

Advantageously, each of the plurality of circuitry branches may include one or more nested circuitry chains, whereby the two or more paths each may include additional splitting circuitry each configured to split the respective path into two or more sub-paths, wherein each of the two or more sub-paths may include the amplification circuitry, and wherein each of the two paths may include additional combining circuitry configured to combine signals received on the sub-paths of the respective path. As such, the PA module power may be further increased, while still maintaining high levels of isolation between output terminals of the PA module.

In some examples, the splitting circuitry includes a plurality of splitting components each configured to split an input signal into two signals, wherein each circuitry branch includes one or more splitting components configured to receive a respective switched signal from the switching circuitry, and provide the plurality of split signals to the amplification circuitry. The splitting components may introduce a phase shift between the two output signals, and may for example be implemented as a hybrid coupler. Alternatively, the splitting components may not introduce a phase shift between the two output signals, and may for example be implemented as a Wilkinson divider or as an active splitter.

In some examples, the combining circuitry includes a plurality of combining components each configured to combine two input signals into a single output signal, wherein a first combining component is configured to combine amplified signals received on multiple paths of a first circuitry branch, wherein a second combining component is configured to combine amplified signals received on multiple paths of a second circuitry branch, and wherein a third combining component is configured to combine outputs of the first and second circuitry branches. The combining components may superimpose signals having a set phase different therebetween, and may for example be implemented as a hybrid coupler or add signals having same phase therebetween, and may for example be implemented as a Wilkinson combiner or as an active combiner.

In some examples, the circuitry further comprises one or more of sensing circuitry, control circuitry, and or calibration circuitry, connected to one or more isolation ports of the plurality of splitting components and/or combining components. As such, the performance of the PA module may be monitored or maintained using integrated circuitry.

The switching circuitry comprises: a switching module, the switching module having a plurality of configurations each arranged to provide an input signal to a different one of a plurality of output terminals of the switching module, wherein the configuration of the switching circuitry is defined by the configuration of the switching module; a splitting component arranged to divide the signal output from the switching module into two equal signals having a defined phase difference therebetween, and attenuation circuitry arranged between the switching component and a splitting component, the attenuation circuitry configured to attenuate the signal output from the switching component, according to the configuration of the switching component. In some implementations, the attenuation circuitry may comprise a plurality of attenuators each corresponding to a respective circuitry branch of the plurality of circuitry branches, wherein an attenuation level of the plurality of attenuators is set according to the configuration of the switching circuitry to maximally attenuate signals on one or more first circuitry branches, and minimally attenuate a second circuitry branch signal. As such, the signals output by the hybrid coupler (and the switching circuitry as a whole) have a more predictable phase and amplitude relationship, meaning that the isolation between the output terminals is further increased.

Advantageously, the attenuation level of the plurality of attenuators may be controlled by one or more control signals also configured to control the configuration of the switching circuitry. As such, the circuitry can be further simplified as well as ensuring that timing of changes in the configuration of the switching component and the attenuation of the attenuators are better matched, allowing for high-speed changes in the selected output terminal,

In some examples, the circuitry may further comprise second amplification circuitry configured to provide an amplified single input signal to the dividing circuitry. Additionally or alternatively, the splitting circuitry may further comprise third amplification circuitry arranged on each of the plurality of circuitry branches between the dividing circuitry and the amplification circuitry.

Accordingly, the PA module gain may be further increased, while still maintaining same output power and high levels of isolation between output terminals of the PA module.

Advantageously, the dividing, splitting and combining circuitry is arranged to align an electrical phase and amplitude of signals on each of the plurality of circuitry branches at the plurality of output terminals. In this manner, the output ports of the PA module are effectively isolated from one another, without relying on a single switching component at the PA module output to provide this high level of isolation.

In some examples, the circuitry is a monolithic integrated circuit. As such, the PA module may be small in size and integrated onto a single chip (i.e. piece of semiconductor material). Consequently, a small chip containing the PA module may be implemented in a wide variety of use cases, in particular where any PA module must have a small form factor.

According to a second example implementation there is provided a system comprising: a power amplifier comprising the circuitry of any of claims 1-13; and a dual-polarization antenna, wherein the plurality of output terminals of the power amplifier are connected to the dual-polarization antenna. As such, due to the high level of isolation provided by the PA modules of the present invention, a dual-polarization antenna may transmit solely using the selected polarization, thereby improving transmission signal quality.

It is to be understood that both the foregoing general description and the following detailed description are exemplary, but are not restrictive, of the present technology. The described embodiments, together with further advantages, will be best understood by reference to the following detailed description taken in conjunction with the accompanying drawings.

### Brief Description of the Drawings

A more complete appreciation of the disclosure and many of the attendant advantages thereof will be readily obtained as the same becomes better understood by reference to the following detailed description when considered in connection with the accompanying drawings wherein like reference numerals designate identical or corresponding parts throughout the several views, and wherein:
Figure 1 illustrates an example of a basic power amplification concept.
Figure 2 illustrates an example of a multi-path power amplifier (MPA) module.
Figure 3 illustrates an example of a Multiple-Input-Multiple-Output (MIMO) MPA module.
Figure 4 illustrates an example of a single-input multiple-output MPA module having selectable output terminals.
Figure 5 illustrates an example MPA module not according to the present invention which is defined by the appended set of claims but useful for understanding the invention.
Figure 6 illustrates example switching circuitry for use in MPA modules not according to the present invention which is defined by the appended set of claims but useful for understanding the invention.
Figure 7 illustrates an example MPA module according to the present disclosure having additional attenuation circuitry.
Figure 8 illustrates an example MPA module according to the present disclosure having additional amplification circuitry.
Figure 9 illustrates a single circuitry branch for an example MPA module according to the present disclosure, where the single circuitry branch includes a nested splitting, amplification, and combining circuitry chain(s).
Figure 10 illustrates an example MPA module according to the present disclosure having additional amplification circuitry at the input of the signal chain.
Figure 11 illustrates a generalised version of an MPA module according to the present disclosure.

### Detailed Description

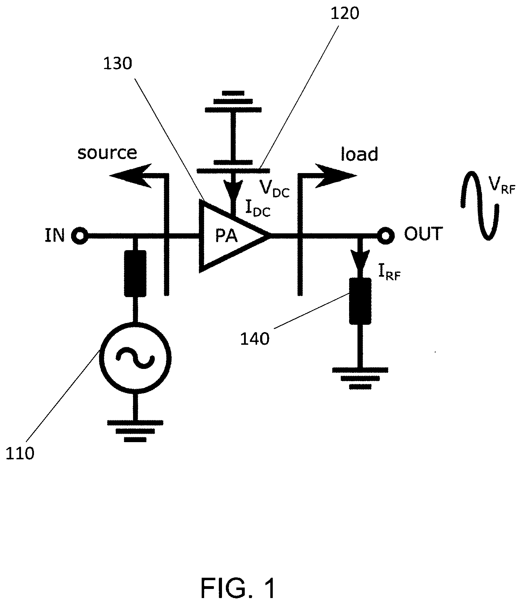

Power amplification in terms of radio-frequency (RF) electronic circuits is achieved via a circuit block called a power amplifier (PA). In principle a PA is an active electronic circuit capable of amplifying a time varying RF signal, provided from an RF source, by using a direct current (DC) power supply. The amplified output signal is delivered over a load as a time varying voltage V_{RF} having a corresponding current I_{RF}. This is illustrated in Figure 1, where the varying RF signal (110) is amplified by a PA 130 using a DC power supply 120, to provide an amplified output signal to a load 140.

In ideal circuitry, the DC power P_{DC}=V_{DC}*I_{DC} would be transformed to an equivalent RF output power defined by V_{RF} and the corresponding current I_{RF}. However, due to physical limitations and losses, only a portion of the P_{DC} is transformed to P_{RF}, such that P_{RF}= η*P_{DC}, where η (%) is the amplifier efficiency. According to established theory and depending on the biasing conditions, a linear amplifier (class A) without any additional loss would achieve a maximum efficiency of η=50%. This means that only half of the available P_{DC} (power from the supply) can be delivered over a suitable load in the form of P_{RF}. The remaining 50% is dissipated in the PA as heat, which is an unwanted side effect of power amplification. It should be noted, however, that more sophisticated biasing schemes may achieve higher efficiency states.

The power ratio between output and input signals G=P_{RF_out}/P_{RF_in} is referred to as the amplifier gain. As long as the PA does not operate in the vicinity of (i.e. close to) its maximum possible output power P_{RF_max}, the gain G is not affected by the input power levels. This is also called the small-signal region, where G is constant over P_{RF_in}. When the PA gets closer to P_{RF_max}, the amplifier starts to compress and gain drops with increasing P_{RF_in}. One such linearity metric is the so called 1dB compression point P_{OUT_1dB}, where the amplifier gain G has dropped by 1dB compared to its small signal (low P_{RF_in}) value. P_{OUT_1dB} is therefore an indicator of the P_{RF_out} power levels up to which an amplifier is capable of nearly linear signal amplification.

Each given active semiconductor device, namely transistor, has certain process parameters, such as nominal supply voltage, maximum breakdown voltage, maximum frequency for amplification f_{T}, and current density (e.g. I_{DC}/mm of transistor channel width), which determine the limits of power amplification for a given DC supply. There is the option of increasing the transistor device size in order to facilitate greater I_{DC} current to be drawn from the DC supply, thus potentially providing greater delivered P_{RF}, however there are several trade-offs and limits to be considered when doing so.

Larger transistor devices have more parasitics (i.e. unwanted resistance/capacitance effects) associated between the device terminals which limit the operating frequency and introduce more losses and less amplifier gain. These factors in turn reduce PA efficiency. In addition, larger devices draw larger supply currents and as such may be easily limited by the current density capabilities of the metals used for carrying the I_{DC}. Each metal conductor can only carry a certain amount of current, before electromigration deteriorates the ohmic performance of the metal. In extreme cases, the conductor can simply fail, resulting an open circuit if too much DC current is drawn from it. Similarly, large devices draw more current and dissipate more heat, which makes temperature management/cooling more challenging.

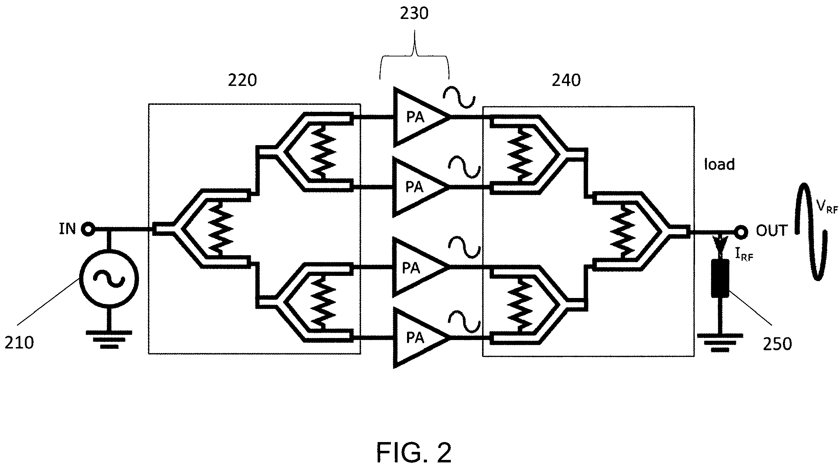

As such, one of the challenges in power amplification modules is to increase the maximum power P_{RF_max} of a PA module in a manner which avoids the above-described bottlenecks with high frequency operation, amplifier gain, linearity and PA efficiency. One approach is to design a multi-path PA (MPA) module, where several unit amplifiers are driven in parallel by a single RF source. Such an MPA is illustrated in Figure 2. The RF input signal 210 is distributed by a splitter network 220 which splits the input signal into multiple RF signals, amplified by the unit amplifiers 230, and the individual amplified RF signals are combined with a suitable power combiner network 240, to provide a single amplified RF signal to a load 250. This topology has the advantage that the individual unit amplifiers can have smaller P_{RF_max} values, whilst the overall P_{RF_max} value of the MPA is increased relative to the arrangement in Figure 1. Thus, improved heat management, high-frequency gain, and relaxed I_{DC} current specification are achieved. However, in designing MPAs, it is required to implement a power combining network that exhibits minimal losses, in order to retain good PA module efficiency, since any loss at the PA outputs cannot be recovered and will directly reduce the PA efficiency. The MPA topology allows a PA module to reach P_{RF} levels that would not be feasible with a single up-scaled PA unit.

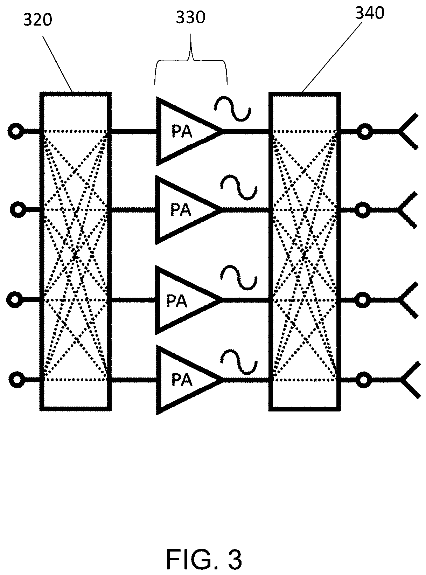

Multi-path PA concepts can also be expanded to Multiple-Input-Multiple-Output (MIMO) or Butler Matrix topologies, where in a general case N-inputs can be distributed, amplified and/or weigthed and combined to M-ouputs, with N≠M. This is illustrated in Figure 3, which shows a MIMO MPA topology, where for illustrative simplicity N=M=4, however it should be appreciated that various values of N and M may be used, such that N≠M. The MIMO MPA of Figure 3 includes 4 input signals which pass through an input network 320 (such as a Butler Matrix) which may perform operations such as phase shift and/or switching, based on the desired operation e.g. beam-forming at an antenna array. The signals are amplified by amplification circuitry 330, and then pass through an output network 340 (such as a Butler Matrix), which, like the input network 320, may perform operations such as phase shift and/or switching, based on the desired operation. The input signals of such MPA or Butler Matrix systems are not necessarily identical but can be individually controlled as to achieve a certain RF functionality at the MPA outputs. Alternatively, MPA implementations can be used to route and amplify individual input signals to certain output ports.

The above-described amplifier topologies can provide single or multiple outputs, where signals are always provided to all output ports when an input RF signal is provided. However, in some applications, the combined P_{RF_out} of a PA module needs to be provided at a particular output port (i.e. only one output port at a given time), while the other output ports should remain isolated (at a reference impedance) and thus not deliver any power. An example application for such an arrangement is a dual-polarized antenna, where antennas corresponding to different polarization states must be activated individually at different times. Such dual-polarization antennas are typical for flat antenna arrays and satellite dishes of VSAT satellite communications.

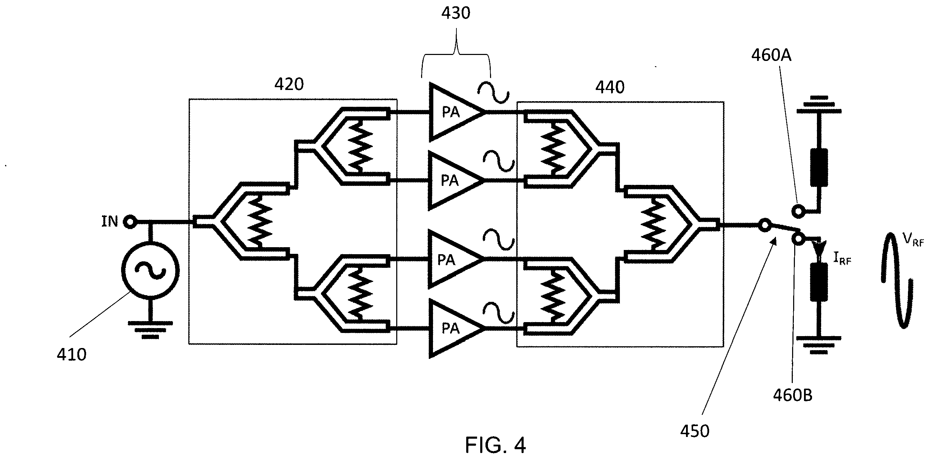

An example of such an arrangement is shown in Figure 4. The topology is similar to that shown in Figure 2, where the RF input signal 410 is distributed by a splitter network 420 which splits the input signal into multiple RF signals, amplified by the unit amplifiers 430, and the individual amplified RF signals are combined with a suitable power combiner network 440, to provide a single amplified RF signal. The single amplified RF signal, having entire output power P_{RF} of the PA module, is then delivered through a Single-Pole-Double-Throw (SPDT) switch 450 having two output ports 460A, 460B allowing the MPA module to selectively deliver the amplified RF signal to one of two loads.

This arrangement allows an MPA to selectively deliver power to a particular output port 460, based on the position of the SPDT switch 450. In such arrangements, both output ports 460 should be isolated from one another, such that when output port 460B is selected (as in Figure 4), no power is delivered to output port 460A. However, in practice the SPDT switch 450 will have finite isolation properties, meaning that P_{RF_out}≠0 at output port 460A. The isolation metric in this case is defined as the difference of power levels between the two output ports. Iso= P_{RF_out@OUT2}- P_{RF_out@OUT1}.

In the arrangement of Figure 4, the SPDT switch 450 needs to be highly linear up to P_{RF_out} so as not to deteriorate the shape of the V_{RF} waveform. At higher power levels, such as 2W (33dBm), this is challenging to implement at mm-wave frequencies. The finite isolation of the SPDT at the output of the MPA module, therefore limits the functionality of such a switched dual-output PA, particularly at higher power levels, such as 2W. In particular, in the arrangement of Figure 4 good isolation (e.g. >30dB of isolation) cannot be readily achieved at mm-wave frequencies, or can be achieved only at the expense of circuit complexity/loss at the SPDT switch 450. In addition, in the arrangement of Figure 4 the insertion loss of the SPDT switch 450 is higher than comparative combiner network losses (such as those shown in Figure 2), meaning the gain and efficiency of the PA module are both reduced. These losses at the SPDT switch 450 mean that larger P_{RF_out} values are required at the individual PA unit amplifiers in order to achieve the same overall power, which has negative implications on heat management, amplifier linearity and module gain.

The present inventors have identified a new circuitry arrangement for a single-input multiple-output multi-path power amplifier which addresses these drawbacks in existing approaches. The circuitry comprises switching circuity configured to receive a single input signal and provide a plurality of switched signals having different phases to a plurality of circuitry branches, wherein a phase of each of the plurality of switched signals provided to respective circuitry branches is determined by a configuration of the switching circuitry, the switching circuitry having a plurality of possible configurations, and wherein a number of circuitry branches corresponds to a number of possible configurations of the switching circuitry. The circuitry further comprises splitter circuitry arranged in each of the plurality of circuitry branches and configured to receive a respective switched signal and provide a plurality of split signals on the respective circuitry branch. The circuitry further comprises amplification circuitry arranged in each of the plurality of circuitry branches and configured to receive the plurality of split signals on the respective circuitry branch, wherein the amplification circuitry is configured to amplify the plurality of split signals to provide a plurality of amplified signals. The circuitry further comprises combiner circuitry configured to receive the plurality of amplified signals from each of the plurality of circuitry branches and provide a single output signal to one of a plurality of output terminals, wherein a number of output terminals corresponds to the number of possible configurations of the switching circuitry, and wherein the single output signal is provided to a particular one of the plurality of output terminals according to the configuration of the switching circuitry.

The switching circuitry may in some cases comprise: an SPDT switch having two possible configurations, and a hybrid coupler, wherein the SPDT switch is configured to provide a single signal to the hybrid coupler, and wherein the hybrid coupler is configured to provide an in-phase signal to either a first or second circuitry branch of the plurality of circuitry branches and provide a quadrature signal to the other of the first or second circuitry branches according to the configuration of the SPDT switch; wherein the plurality of output terminals comprise two output terminals. However, while the invention is described primarily in relation to an arrangement using a SPDT switch and having two possible outputs and two configurations for the switching circuitry, it should be appreciated that other arrangements are possible, whereby the circuitry uses a switching component having more than two configurations, and has more than two outputs and more than two configurations for the switching circuitry. As such, the advantages discussed herein in relation to a single-input dual-output arrangement, should be considered to be generally applicable to other single-input multiple (greater than 2)-output arrangements.

In particular, rather than relying on a single SPDT switch to provide isolation between output ports, or using complex dedicated isolation circuitry, the circuitry disclosed herein balances the phase and amplitude relationships between multiple circuitry branches, and locates the switching circuitry at the beginning of the signal chain, in order to achieve isolation levels not otherwise possible at mm-wave frequencies.

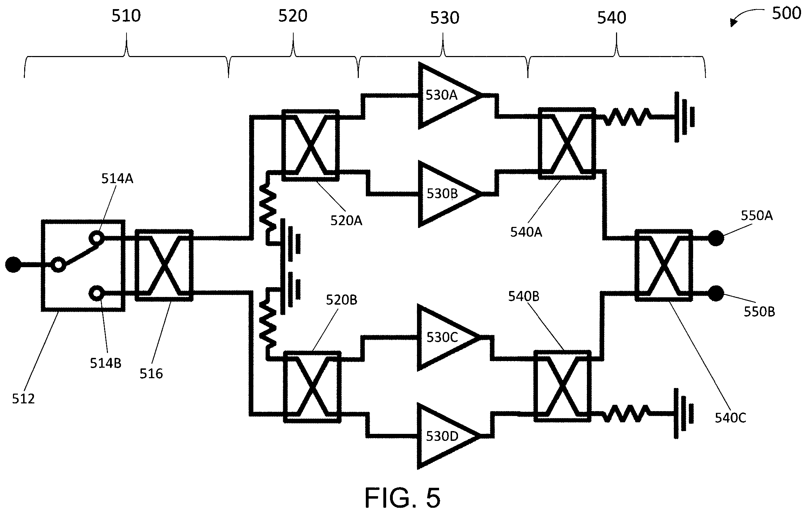

An example of the circuitry 500 not according to the present invention but useful for understanding the invention is shown in Figure 5. As discussed above, the circuitry 500 includes switching circuitry 510, splitting circuitry 520, amplification circuitry 530, and combining circuitry 540. The switching circuitry 510 may include an SPDT switch 512 having two output ports 514A, 514B, and a hybrid coupler 516 arranged to receive a signal from either of the two output ports 514. A hybrid coupler is a four-port network that has two input ports and two output ports, with the property that an input signal at one port is divided equally between the two output ports with a phase shift of 90 degrees between the two outputs, while an input signal at the other input port is divided equally but with an opposite phase shift of 90 degrees between the two output ports. When an input signal is provided on one input port of the hybrid coupler, the other input port is isolated from the signal and terminated with the system impedance Z₀. As such, an in-phase (I) signal is provided to one output port of the hybrid coupler 516, and a quadrature (Q) signal is provided to the other output port of the hybrid coupler 516, where the ports to which the I/Q signals are provided is determined by the position of the SPDT switch 512 (i.e. which output port 514 is selected).

As discussed above, the switching circuitry 510 provides an output signal on a plurality of circuitry branches, where the phase of the signal on a particular circuitry branch is determined by the configuration of the switching circuitry 510, as discussed above. For example, the output ports of the hybrid coupler 516 are each connected to a separate circuitry branch. In the example of Figure 5, a first circuitry branch includes a splitting component 520A, power amplifiers 530A and 530B, and a combining component 540A, while a second circuitry branch includes a splitting component 520B, power amplifiers 530C and 530D, and a combining component 540D. Combining component 540C may be considered to be part of both the first and circuitry branches, or may not be considered to be part of any of the circuitry branches.

On the first circuitry branch, the splitting component 520A divides the received signal from the switching circuitry 510 into two (or more) signals. In addition to splitting the signal, the splitting component 520A may in some cases perform one or more additional operations on the signals, such as imparting a phase shift between the two signals. For example, the splitting component 520A may be a hybrid coupler which splits the input signal into equal I and Q signals (i.e. signals with a 90 degree phase difference therebetween). In such cases, an input signal from the switching circuitry is provided to an input port of the hybrid coupler, where the other input port is isolated from said input signal and may be terminated by an appropriate impedance in order to provided ideal input loading to the isolated port of the hybrid coupler. Alternatively, the splitting component 520A may, for example, be a divider which splits the input signal into two equal signals having a phase difference therebetween that is different to 90 degrees. For example, other dividers with phase shifters may be used which provide a phase difference of, for example, 180 degrees, 60 degrees, 45 degrees, or 30 degrees, between the output signals. As just one specific example, a Wilkinson divider may be utilised with a phase shifter to split the input signal and introduce a phase shift between the two output signals. On the second circuitry branch, the splitting component 520B is arranged in identical manner to the splitting component 520A of the first circuitry branch. It should however be appreciated that the splitting components 520A-B of the splitting circuitry 520 may in some cases not generate any phase difference between the split signals.

After the signal on each branch has been split by the respective splitting components 520, the split signals on each branch are amplified by the amplification circuitry 530. In Figure 5, the amplification circuitry 530 includes PAs 530A and 530B arranged on the first circuitry branch, and PAs 530C and 530D arranged on the second circuitry branch. PAs 530A and 530B are arranged on different paths (connected to outputs of the splitting component 520A) of the first circuitry branch, and PAs 530C and 530D are arranged on different paths (connected to outputs of the splitting component 520B) of the second circuitry branch. PAs 530A-D amplify the received signals in the same manner as described above in relation to Figure 1. The DC power supply used in Figure 5 is not shown for ease of illustration. Furthermore, the amplification circuitry 530 in each circuitry branch is identical.

After being amplified by the amplification circuitry 530, the amplified signals on each circuitry branch are combined using combining circuitry 540. First, the multiple paths on each circuitry branch are combined by first and second combining components 540A, 540B. That is, the two paths on the first circuitry branch are combined by combining components 540A, and the two paths on the second circuitry branch are combined by combining component 540B. The combining components 540A-B may be generally identical (in terms of phase control) to the splitting components 520A-B. For example, if splitting component 520A is a hybrid coupler, then the combining component 540B may also a hybrid coupler to ensure that the out-of-phase signals on the multiple paths of the circuitry branch are predictably combined. Similarly, if splitting component 520A is a divider and phase shifter combination with a phase difference other than 90 degrees, then the combining component 540B has a corresponding arrangement where signals with the same phase difference as that introduced by the splitting circuitry are combined. For example, if the splitting circuitry introduces a 180 degree phase difference between the split signals, the combining component are arranged to combine signals having a 180 degree phase difference therebetween. As such, the two amplified signals are combined into a single output signal, where any phase difference applied to one of the output signals of the splitting component 520A is applied to one of the input signals of the combining component. The combining component 520A may therefore be arranged to superimpose signals having the exact phase difference introduced by the splitting component 520A. It should however be appreciated that the combining components 540A-B of the combining circuitry 540 may in some cases not take into account any phase difference between the split signals, for example if the splitting components 520A-B are conventional signal dividers which do not generate any phase difference between the split signals.

If a hybrid coupler is used for the splitting component 520A, the signals on the two paths received from the PAs 530A-B are connected to the so-called 'output' terminals of the hybrid coupler 540A, to provide a single signal to one of the two 'input' terminals of the output hybrid coupler 540C. The 'input' terminal of 540A on which the combined signal is not provided is the isolated port, which may be terminated by the appropriate impedance. The hybrid coupler 540B used in correspondence of the splitting component 520B is arranged in the same way, with the isolated port terminated by an appropriate impedance.

After the multiple paths on each circuitry branch have been combined to provide a single signal for each branch, a final combining component 540C is arranged to combine the signals from each circuitry branch. For example, in Figure 5 the final combining component 540C combines the signals received from the combining components 540A-B for the first and second circuitry branches respectively. The final combining component 540C combines the signals from the circuity branches in a manner which superimposes signals having the exact phase shift between the circuitry branches introduced by the switching circuitry 510. For example, hybrid coupler 516 may be used to introduce a 90 degree phase shift, such that an in-phase (I) signal is provided on the first circuitry branch (via splitting component 520A and combining component 520A), and a quadrature (Q) signal is provided on the second circuitry branch (via splitting component 520B and combining component 520B), based on the selection of port 514B of the SPDT switch 512. In such an example, the final combining component 540C may be a hybrid coupler arranged to combine the quadrature signals from the first and second circuitry branches respectively to provide a single signal to output port 550A, where output port 550B is isolated from output port 550B and is impedance matched to the load impedance. Alternatively, if port 514A of the SPDT switch 512 is selected, the in-phase (I) signal is provided to the second circuitry branch and the quadrature (Q) signal is provided to the first circuitry branch, and the final combining component 540C is arranged to combine the quadrature signals from the first and second circuitry branches respectively to provide a single signal to output port 550B, where output port 550A is isolated from output port 550B and is impedance matched to the load impedance. In the event that a non-90 degree phase difference is used, the divided signals may be referred to as an in-phase signal and an out-of-phase signal.

The circuitry according to the present disclosure (as exemplified in Figure 5) provides a single-input multiple-output PA with high quality isolation between the output ports. For example, this arrangement may provide >30dB or even >45dB of isolation between the output ports. In particular, the location of the switching circuitry at the beginning of the signal chain, and the balancing of the phase and amplitude relationships between the multiple circuitry branches, achieves isolation levels not otherwise possible at mm-wave frequencies. Rather than relying upon a single switch to ensure isolation between output ports (as in Figure 4) or adding complex isolation circuitry, the present disclosure uses identical circuitry branches such that the I/Q (or other phase relationship) signals on the multiple circuitry branches follow symmetrical paths (i.e. identical paths on different circuitry branches) and are equally superimposed at the final combiner component by ensuring that the phase difference between signals on the branches is exactly maintained and that the amplitude of signals on the circuitry branches is equal. The identical circuitry branches include identical arrangements of components, however each identical circuitry branch may carry signals having different phases to one another.

This high level of isolation between the output ports makes the PA modules disclosed herein suitable for a variety of use cases where high levels of isolation are a necessity. An example of such a use case is a dual-polarization antenna, where output ports of the PA module may be connected to a transmitter(s) arranged to transmit RF signals with either horizontal or vertical polarisation. It should be appreciated that this is, however, only one example use of the PA modules disclosed herein, and that the use of the PA modules is not limited to this specific use case.

Furthermore, the power combiner network at the output (e.g. combining circuitry 540) is a passive network (i.e. without any active components such as transistors, or diodes), and is thus is not affected by signal power levels and behaves linearly. Moreover, the insertion loss of such a combiner network is significantly lower than any high-power handling SPDT needed to ensure adequate isolation in alternative topologies, such as 450 of Figure 4, and even more so if taking into account the insertion loss of the combiner network of an MPA driving such SPDT, such as 440 of Figure 4. Therefore, PA gain, linearity and efficiency are all improved by the present circuitry.

In addition, as the switching circuitry (e.g. SPDT switch) is located before the splitting, amplification and combining circuitry (i.e. closer to the input signal than the splitting, amplification and combining circuitry), the requirements for the SPDT switch (or other switching circuitry or components thereof) are simplified as there is no need for large signal handling capability, since the primary power amplification stages are introduced later in the signal chain. Furthermore, linearity requirements for the SPDT itself are relaxed for the present circuitry and the removal of the SPDT from the output of the MPA module does not negatively affect the gain or the output power of the PA module.

Moreover, the combining circuitry located close to the output stage may provide further desensitization for the unit amplifiers, as in the case with the properly terminated hybrid couplers 540A and 540B of Figure 5, since any impedance variation at the unit PA outputs will not be propagated directly to the final hybrid coupler. As a result, the impedances seen by the final combining component for a given unit PA are largely determined by the combining components connected to the PA outputs. This combining circuitry allows for the above-discussed symmetric signal paths, thus minimizing phase and amplitude mismatches, which as discussed above results in good isolation performance between the two outputs.

The switching circuitry according to the present disclosure is exemplified in Figure 5 by switching circuitry 510, which includes a SPDT switch 512 and a hybrid coupler 516. More generally, the switching circuitry includes a switching module, the switching module having a plurality of configurations each arranged to provide an input signal to a different one of a plurality of output terminals of the switching module, wherein the configuration of the switching circuitry is defined by the configuration of the switching module. The switching module additionally includes a splitting component arranged to divide the signal output from the switching module into two equal signals having a defined phase difference therebetween, where the phase of the equal signals is determined by the configuration of the switching module.

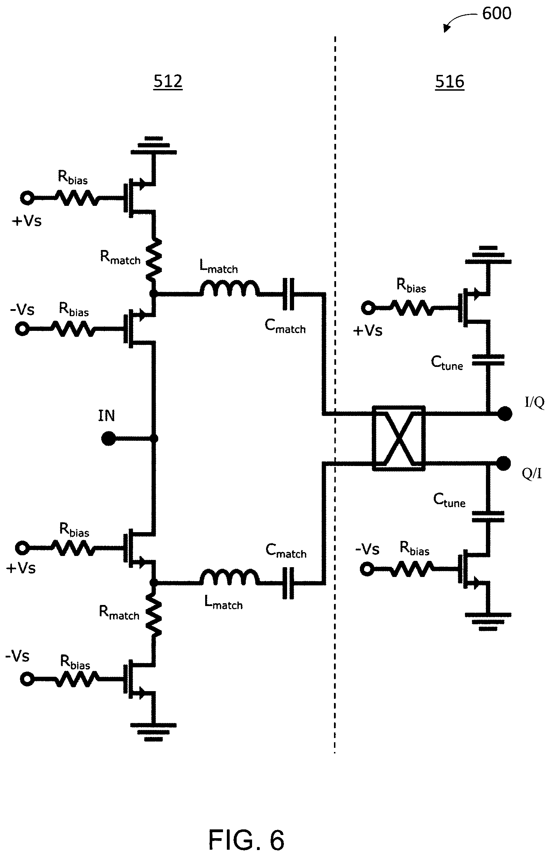

Figure 6 illustrates a more detailed view of an example of switching circuitry 600, such as the switching circuitry 510 shown to Figure 5. The switching circuitry 600 of Figure 6 may be logically divided to include an implementation of a SPDT switch 512 to the left of the vertical dashed line, and a hybrid coupler 516 to the right of the dashed line. The example switching circuitry 600 shown in Figure 6 includes field-effect transistors (FETs) arranged to selectively couple the input RF signal to a particular input terminal of the hybrid coupler 516. The switching circuitry 600 includes multiple paths, each corresponding to an output selection (i.e. a configuration of the switching circuitry), where each path is connected to the hybrid coupler 516. The state of the FETs are set using a setting voltage determined based on which output is selected.

As shown in Figure 6, gates of the FETs are connected to setting voltages of opposite polarities (+Vₛ and -Vₛ). The sign of Vₛ with respect to ground sets the state of the FETs. FETs connected to the same setting voltage have the same state (i.e. setting). As an example for a positive Vₛ, FETs connected to (-Vₛ) are set open, FETs connected to (+Vₛ) are set closed, and as such a first path (the bottom path in Figure 6) of the switching circuitry is activated and a second path (the top path in Figure 6) of the switching circuitry is deactivated, such that an input signal is provided to a first input terminal (the bottom input terminal in Figure 6) of the hybrid coupler 516. Consequently, an in-phase signal is output on a first circuitry branch (the top branch in Figure 6), while a quadrature signal is provided on a second circuitry branch (the bottom branch in Figure 6). Conversely for a negative Vₛ, FETs connected to (+Vₛ) are set open, FETs connected to (-Vₛ) are set closed, and as such the second path (the top path in Figure 6) of the switching circuitry is activated and the first path (the bottom path in Figure 6) of the switching circuitry is deactivated, such that an input signal is provided to a second input terminal (the top input terminal in Figure 6) of the hybrid coupler 516. As such, an in-phase signal is output on the second circuitry branch (the bottom branch in Figure 6), while a quadrature signal is provided on the second circuitry branch (the top branch in Figure 6). Figure 6 also reports the simplest implementation of compensation circuitry consisting of a Cₜᵤₙₑ element coupling the output of the hybrid coupler 516 to AC ground through a controlled FET (Vₛ,-Vₛ) that may be used to compensate for the impact of non-ideal behaviour of the SPDT switch 512, which result in deviations of the in-phase and quadrature signals from their ideal phase.

Figure 6 shows just one example of the switching circuitry according to the present disclosure, and it should be appreciated that the switching circuitry may be implemented in a number of different ways. For example, instead of FETs, diodes, attenuators and/or amplifiers may be used to achieve the same result. Furthermore, while the switching circuitry discussed herein and illustrated in Figure 6 is discussed herein primarily in relation to the power amplification circuitry according to Figure 5, it should be appreciated that the switching circuitry (such as switching circuitry 600) may be implemented in other power amplification circuitry, as well as in other applications not concerned with power amplification.

While Figure 5 illustrates a basic example of the present circuitry, it should be appreciated that various modifications relative to the circuitry 500 of Figure 5 are possible. For example, as discussed above the switching circuitry may provide more than two output signals with different phases to more than two circuitry branches, where more than two output ports are provided. For example, with three circuitry branches, the switching circuitry may include a switching component that outputs a signal to one of three terminals and one or more splitting components that output three signals on three circuitry branches with a constant phase shift between each signal, where the phase of the signal output to the circuitry branches is determined by the terminal selected for the switching component. For example, the phase shift may e.g. be 90 degrees, 60 degrees, 45 degrees, or 30 degrees and may be selected in order to accommodate different number of selectable outputs (i.e. different numbers of configurations of the switching circuitry).

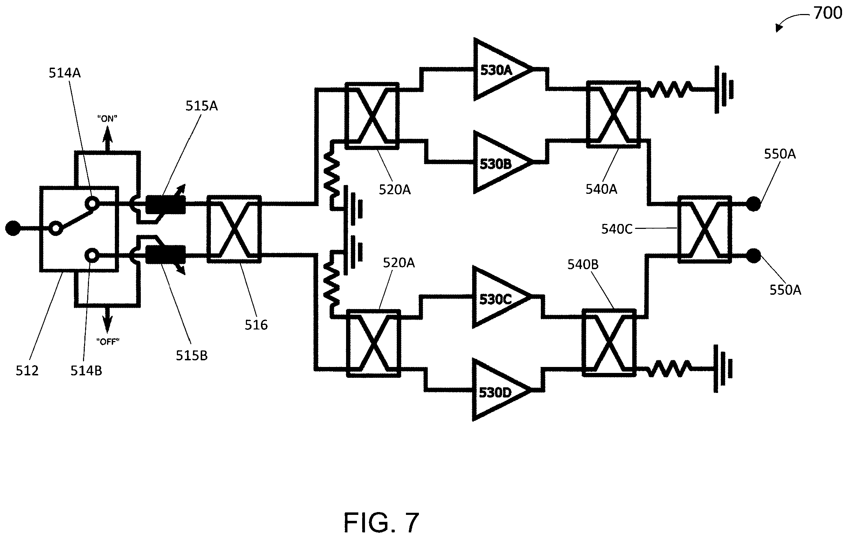

Figure 7 illustrates circuitry according to the present disclosure. In particular, the circuitry 700 shown in Figure 7 is similar to the circuitry 500 shown in Figure 5, where like reference numerals denote identical components. In addition to the components of the circuitry 500 of Figure 5, the circuitry 700 of Figure 7 includes attenuators 515 located between the SPDT switch 512 and the hybrid coupler 516 arranged to selectively attenuate signals output by the SPDT switch 512. An attenuator 515A, 515B is provided for each output of the SPDT switch 512, where the attenuation level of the attenuators 515A-B is set according to the configuration of the SPDT switch 512. For example, if terminal 514A of the SPDT switch 512 is selected (i.e. is "ON"), the attenuator 515A, which is arranged on the signal chain for (i.e. in series with) signals output from terminal 514A, is set to a comparatively low (e.g. minimum possible) attenuation level for the attenuator 515A. Conversely, when terminal 514A of the SPDT switch 512 is selected, the attenuator(s) 515B corresponding to the other un-selected terminal(s) 514B of the SPDT switch 512 (i.e. the attenuators 515B arranged on the signal chain for signals output from the un-selected terminals 514B) are set to a comparatively high (i.e. maximum possible) attenuation level for the attenuator 515B.

The implementation of attenuators 515 in this way further improves isolation within the switching circuitry. That is, while the circuitry according to the present disclosure relaxes the isolation requirements for the switching circuitry (as discussed above), in some implementations (depending on the specific components used) the switching circuitry (i.e. the SPDT switch 512) may still not provide perfect isolation between the terminals 514A-B, despite the RF signal provided as input to the switching circuitry being of comparatively low amplitude. The use of attenuators 515 to selectively attenuate signals output from the SPDT switch 512 (or other switching component) before the hybrid coupler 516 (or other splitting component) based on the configuration of the SPDT switch 512 minimises the provision of any unwanted signals to the hybrid coupler 516. As such, the signals output by the hybrid coupler (and the switching circuitry as a whole) have a more predictable phase and amplitude relationship, meaning that the isolation between the output terminals 550A-B is further increased when the signals are combined at the final combining component 540C.

Furthermore, as shown in Figure 7, the attenuation level of the attenuators 515 may be controlled using the same control signal used to control the configuration of the SPDT switch 512 (or other switching component). By using the same control signal for the switching component and the attenuators 515 in this way, the circuitry 700 can be further simplified and compacted as well as ensuring that the timing of changes in the configuration of the switching component and the attenuation of the attenuators are better matched, allowing for more precise high-speed changes in the selected output terminal, for example in pulse-width modulation (PWM) signalling.

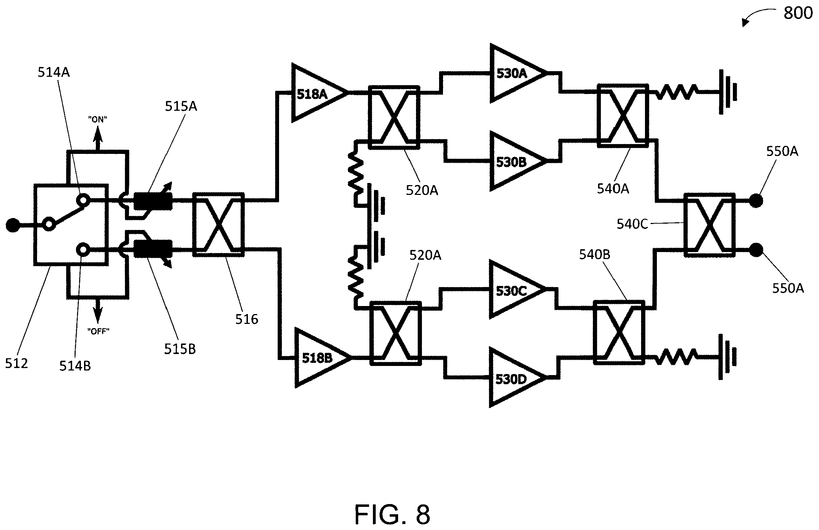

In addition, the circuitry 500 of Figure 5 can be modified to include additional unit PAs within the circuitry. For example, when attenuators 515 are implemented as shown in Figure 7, the gain of the PA module 700 can be reduced. As such, it may particularly advantageous to use additional amplification within the circuitry, in order to increase the gain, while maintaining high levels of isolation between the output ports. Figure 8 illustrates circuitry 800 including this additional modification where the circuitry 800 shown in Figure 8 is similar to the circuitry 700 shown in Figure 7, where like reference numerals denote identical components. In addition to the components of the circuitry 700 of Figure 7, the circuitry 800 of Figure 8 includes additional PAs 518 located on each of the circuitry branches before one or more splitting components of the splitting circuitry (i.e. earlier in the signal chain than the splitting components 520A). As such, the overall gain of the PA module 900 may be further increased while achieving adequate isolation levels, due to significant isolation provided through the placement of the switching circuitry and identical circuitry branches. Furthermore, it should be appreciated that while the circuitry 800 of Figure 8 includes the attenuators 515 discussed in relation to Figure 7, the additional PAs 518 provided in the circuitry 800 of Figure 8 may be provided without the attenuators 515.

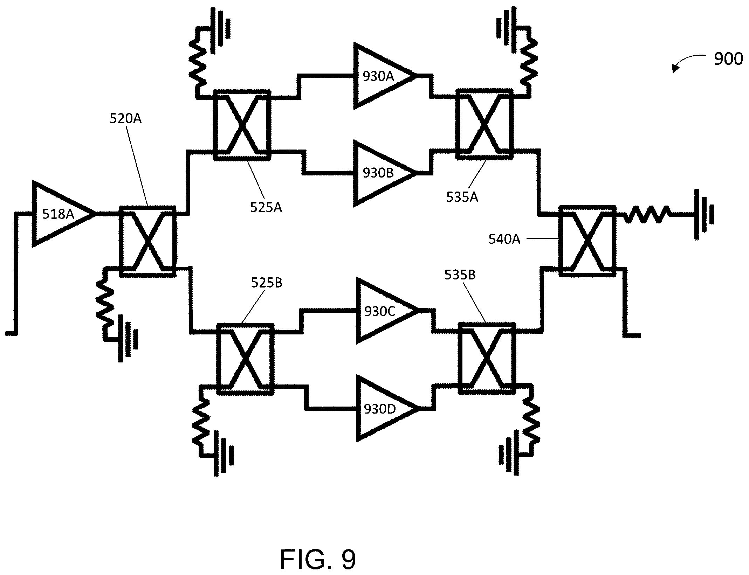

While Figure 8 illustrates a specific manner of adding additional amplification circuitry, additional amplification circuitry may be generally added to various sections of the circuitry, while maintaining the isolation between the output ports at acceptable levels. For example, each circuitry branch may include nested circuitry chains, each including splitting, amplification and combining circuitry. An example is shown in Figure 9, which illustrates a single circuitry branch 900. The circuitry branch includes the splitting component 520A and combining component 540A shown in Figures 5, 7, and 8 and the additional PA 518A shown in Figure 8. The circuitry branch 900 includes additional splitting components 525A and 525B, which further split the signal provided by the splitting component 520A in a similar manner to that already described herein, such that the circuitry branch 900 has four paths, each including a unit PA 930A-D. The circuitry branch then includes a combining component 535A arranged to combine the signals received from the PAs 930A-B in a similar manner to that already described herein and a combining component 535B arranged to combine the signals received from the PAs 930C-D in a similar manner to that already described herein.

As such, additional amplification circuitry can be added to each circuitry branch, to further increase the gain of the PA module. Moreover, it should be appreciated that further PAs may be added which are not shown in Figures 9, such as between splitting component 520A and splitting components 525A and 525B. Furthermore, additional layers may be added to the circuitry branch 900, such that the signals output by splitting components 525A-B may be divided further, amplified, and combined/superimposed, in order to provide a nested circuitry chain having additional layers not shown in Figure 9. It should also be appreciated that Figure 9 illustrates only one circuitry branch of a PA module, and that the PA module will include one or more additional circuitry branches, each having an identical arrangement of components.

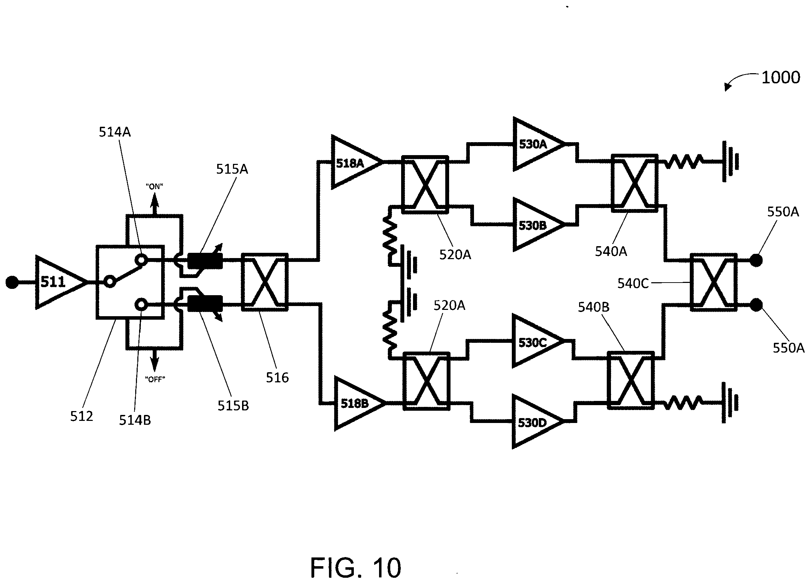

Figure 10 shows another example of circuitry 1000 including additional amplification circuitry. The circuitry 1000 shown in Figure 10 is similar to the circuitry 800 shown in Figure 8, where like reference numerals denote identical components. In addition to the components of the circuitry 800 of Figure 8, the circuitry 1000 of Figure 10 includes a further PA 511 located before (in the signal chain) the switching component 512 (e.g. the SPDT switch). As such, the overall gain of the PA module 1000 may be further increased while achieving adequate isolation levels, due to significant isolation provided through the placement of the switching circuitry and identical circuitry branches. Furthermore, it should be appreciated that while the circuitry 1000 of Figure 10 includes the attenuators 515 discussed in relation to Figure 7, and the additional PAs 518 discussed in relation to Figure 8, the further PA 511 shown in Figure 10 may be provided without the attenuators 515 or additional PAs 518. In general, additional PAs are located prior (in the signal chain) to any combining component in order to maintain the combining network as a passive network, which allows the phase and amplitude relationships of the amplified signals to be more accurately aligned at the final combining component 540C shown in Figures 5, 7, and 8, by filtering out impedance variations.

As illustrated in Figures 5 and 7-10 and discussed above, the splitting and/or combining components included in the splitting circuitry or combining circuitry may include isolated ports which are terminated by an appropriate impedance. In Figures 5 and 7-10, these loads are shown as resistors, however in some cases other components may be located here instead or in addition to resistors. For example, sensing circuitry may be connected to the isolated ports and may be utilised, for example, to measure the power of signals on a particular circuitry branch. In these cases, the sensing circuitry may e.g. be connected to the isolated ports of combining components 540A and 540B to measure the power of the signals fed to the final combining component 540C, where detectable signal is present due to high power level at the output of the amplifying paths and the finite isolation of the combining components 540A and 540B; the detected power level can be used to feed calibration or other control circuitry. In addition or as an alternative to sensing circuitry, calibration circuitry or control circuitry may be also directly connected to the isolated ports of the splitting or combining components, and may be utilised, for example, to adjust the load in order to alter the reference impedance at which the isolated port of the splitting or combining component is maintained.

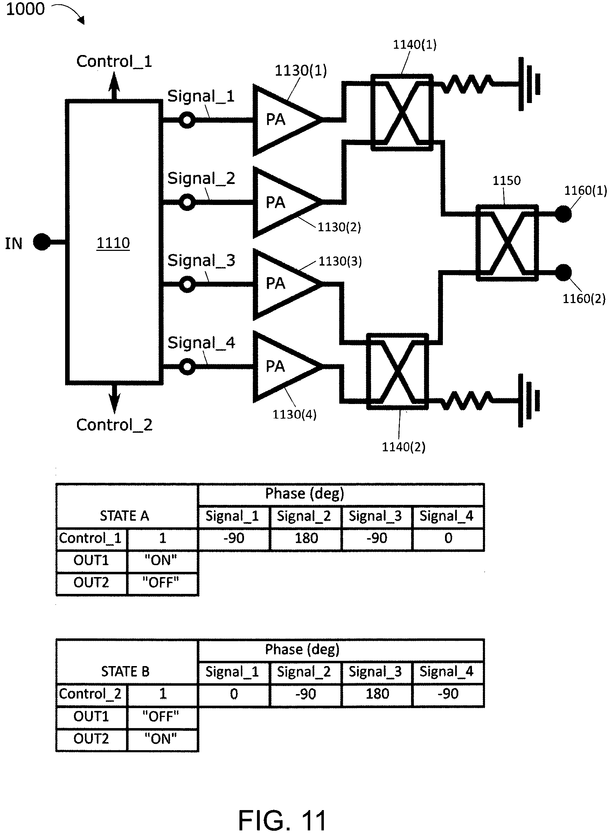

While Figures 5 and 7-10 show specific implementations of circuitry according to the present disclosure, the circuitry according to the present disclosure is more generally illustrated in Figure 11. In particular, the switching circuitry 510 and splitting circuitry 520 described above may be considered to be specific implementations of a Butler matrix, wherein dividing circuitry 1110 (i.e. the Butler matrix) is arranged to receive a single input signal and provide four or more signals with defined phase relationships. In particular, the dividing circuitry 1110 shown in Figure 11 provides four signals across two circuitry branches. That is, the dividing circuitry 1110 outputs signals Signal_1 and Signal_2 which may considered to be located on a first circuitry branch, and the dividing circuitry 1110 outputs signals Signal_3 and Signal_4 which may considered to be located on a second circuitry branch. The signals of each circuitry branch have a defined phase relationship with respect to one another, where the phases of the signals depends on a state of the dividing circuitry 1110. The state of the dividing circuitry 1110 determines a particular output terminal 1160 to which an output signal is provided (i.e. the output terminal is "on"), while the other output terminal is isolated (i.e. the output terminal is "off"). The state of the dividing circuitry 1110 may be controlled by control signals Control_1 and/or Control_2.

In the example of Figure 11, the dividing circuitry 1110 has two possible states: State A, and State B. In State A, the signals provided by the dividing circuitry 1110 have the phase relationships defined in the upper table of Figure 11. In State B, the signals provided by the dividing circuitry 1110 have the phase relationships defined in the lower table of Figure 11. The signals provided by the dividing circuitry 1110 are then passed to amplifiers 1130(1)-1130(4). Combining component 1140(1) combines the signals on the first circuitry branch, and combining component 1140(2) combines the signals on the second circuitry branch. Final combining component 1150 then combines the signals from both circuitry branches. In State A, the combining component 1150 provides an output signal to output terminal 1160(1), while output terminal 1160(2) is isolated. Conversely, in State B, the combining component provides an output signal to output terminal 1160(2), while output terminal 1160(1) is isolated.

In the specific example of Figure 11, the dividing circuitry 1110 provides signals having a phase relationship such that two signals having a 90 degree phase difference therebetween are provided to each combining component 1140, 1150. Accordingly, in this example hybrid couplers are used for each of the combining components 1140, 1150. However, it should be appreciated that the dividing circuitry 1110 may provide signals having different phase relationships to those shown in the tables of Figure 11, and that appropriate combining components 1140, 1150 may be selected to combine signals having said different phase relationships. For example, the dividing circuitry 1110 may output to each circuitry branch signals having a 180 degrees, 60 degrees, 45 degrees, or 30 degrees phase difference therebetween, where the combining components 1140, 1150 are each configured to combine signals having a 180 degrees, 60 degrees, 45 degrees, or 30 degrees respectively phase difference therebetween.

The dividing circuitry 1110 may be implemented in any of the manners described above, such as using separate switching circuitry 510 and splitting circuitry 520. However, it should be appreciated that the dividing circuitry 1110 may also be implemented in substantially any other manner which provides a plurality of signals for each circuitry branch having a defined phase difference therebetween, and where the phases of the signals are dependent on a state of the dividing circuitry. The dividing circuitry 1110 may therefore take a number of different forms, and may include any number of passive or active elements.

As discussed above, the circuitry according to the present disclosure provides a single-input multiple-output multi-path power amplifier which provides high levels of isolation between output ports in a manner which does not require complex isolation circuitry. Accordingly, PA modules as disclosed herein can be a monolithic circuity (i.e. a single integrated circuit located on a single semiconductor chip/piece). As such, chips including PA modules as disclosed herein can be made small in size, meaning they can be deployed in a large number of applications. As just one example, chips including a PA module as disclosed herein may be utilised in phased array antennas, where the physical gap between each antenna may be small (e.g. on the order of 5mm for operation in the Ka-band). The small size of the PA modules according to the present disclosure mean they are suitable for deployment in this use case. It should be appreciated that this is, however, only one example use of the PA modules disclosed herein, and that the use of the PA modules is not limited to this specific use case.

Therefore, from one perspective, there has been described circuitry for a single-input multiple-output multi-path power amplifier, the circuitry comprising: switching circuitry arranged to provide a plurality switched signals having a phase difference therebetween to different circuitry branches; a plurality of circuitry branches each including circuitry for splitting the input signal, amplifying the split signals, and combining the amplified signals; and a combining component arranged to superimpose signals received from each of the plurality of circuitry branches into a single output signal and provide the output signal to one of a plurality of output ports. The desired output port is selected via the switching circuitry which is located at the beginning of the signal chain. The circuitry branches are identical such that the phase and amplitude relationships between signals on the different circuitry branches are managed, which, in combination with the location of the switching circuitry, provides for high levels of isolation at the output ports.

## Claims

1. Circuitry (700) for a single-input multiple-output multi-path power amplifier, the circuitry comprising:
switching circuitry (510) configured to receive a single input signal and provide a plurality of switched signals having different phases to a plurality of circuitry branches, wherein a phase of each of the switched signals provided to the circuitry branches is determined by a configuration of the switching circuitry, wherein the switching circuitry comprises:
a switching module (512), the switching module being configured to receive the input signal and having a plurality of possible configurations each arranged to provide the input signal to a different one of a plurality of output terminals (514A, 514B) of the switching module, wherein the configuration of the switching circuitry is defined by the configuration of the switching module, and wherein a number of circuitry branches corresponds to a number of possible configurations of the switching module,
attenuation circuitry (515A, 515B) arranged between the switching component and a splitting component (516), the attenuation circuitry configured to attenuate a signal output from the switching module, according to the configuration of the switching module, and
the splitting component (516) arranged to divide the signal output from the switching module into two equal signals having a defined phase difference therebetween and wherein the two equal signals correspond to the plurality of switched signals;
splitting circuitry (520A, 520B) arranged in each of the plurality of circuitry branches and configured to receive a respective switched signal and provide a plurality of split signals on the respective circuitry branch;
amplification circuitry (530A, 530B, 530C, 530D) arranged in each of the plurality of circuitry branches and configured to receive the plurality of split signals on the respective circuitry branch, wherein the amplification circuitry is configured to amplify the plurality of split signals to provide a plurality of amplified signals;
combining circuitry (540A, 540B, 540C) configured to receive the plurality of amplified signals from each of the plurality of circuitry branches and provide a single output signal to one of a plurality of output terminals (550A, 550B), wherein a number of output terminals corresponds to the number of possible configurations of the switching module, and wherein the single output signal is provided to a particular one of the plurality of output terminals according to the configuration of the switching module.

2. The circuitry according to claim 1, wherein the switching module (512) is:
a single pole double throw, SPDT, switch having two possible configurations, and
wherein the splitting component (516) is a hybrid coupler, wherein the SPDT switch is configured to provide a single signal to the hybrid coupler, and wherein the hybrid coupler is configured to provide an in-phase signal to either a first or second circuitry branch of the plurality of circuitry branches and provide a quadrature signal to the other of the first or second circuitry branches according to the configuration of the SPDT switch;
wherein the plurality of output terminals comprise two output terminals.

3. The circuitry according to claim 1 or claim 2, wherein the attenuation circuitry comprises a plurality of attenuators each corresponding to a respective circuitry branch of the plurality of circuitry branches, wherein an attenuation level of the plurality of attenuators is set according to the configuration of the switching circuitry to maximally attenuate signals on one or more first circuitry branches, and minimally attenuate a second circuitry branch signal.

4. The circuitry according to claim 3, wherein the attenuation level of the plurality of attenuators is controlled by one or more control signals also configured to control the configuration of the switching circuitry.

5. The circuitry according to any preceding claim, wherein the splitting circuitry includes a plurality of splitting components each configured to split an input signal into two signals, wherein each circuitry branch includes one or more splitting components configured to receive a respective switched signal from the switching circuitry, and provide the plurality of split signals to the amplification circuitry.

6. The circuitry according to any preceding claim, wherein the combining circuitry includes a plurality of combining components each configured to combine two input signals into a single output signal, wherein a first combining component is configured to combine amplified signals received on multiple paths of a first circuitry branch, wherein a second combining component is configured to combine amplified signals received on multiple paths of a second circuitry branch, and wherein a third combining component is configured to combine outputs of the first and second circuitry branches.

7. The circuitry of claim 5 or claim 6, further comprising one or more of sensing circuitry, control circuitry, compensation circuitry, and or calibration circuitry, connected to one or more ports of the plurality of splitting components and/or combining components.

8. The circuitry according to any preceding claim, wherein each of the plurality of circuitry branches includes two or more paths, each of the two or more paths configured to receive a particular one of the plurality of split signals and each of the two or more paths including the amplification circuitry.

9. The circuitry according to claim 8, wherein each of the plurality of circuitry branches includes one or more nested circuitry chains, whereby the two or more paths each include additional splitting circuitry each configured to split the respective path into two or more sub-paths, wherein each of the two or more sub-paths includes the amplification circuitry, and wherein each of the two paths includes additional combining circuitry configured to combine signals received on the sub-paths of the respective path.

10. The circuitry according to any preceding claim, further comprising:
second amplification circuitry (511) arranged to provide an amplified single input signal to the switching circuitry.

11. The circuitry according to any preceding claim, further comprising:
third amplification circuitry (518A, 518B) arranged on each of the plurality of circuitry branches between the switching circuitry and the splitting circuitry.

12. The circuitry according to any preceding claim, wherein the switching, splitting and combining circuitry is arranged to align an electrical phase and amplitude of signals on each of the plurality of circuitry branches at the plurality of output terminals.

13. The circuitry according to any preceding claim, wherein the circuitry is a monolithic integrated circuit.

## Patentansprüche

1. Schaltungsanordnung (700) für einen Mehrwege-Leistungsverstärker mit einem Eingang und mehreren Ausgängen, wobei die Schaltungsanordnung Folgendes umfasst:
ein Schaltnetzwerk (510), das dafür ausgelegt ist, ein einziges Eingangssignal zu empfangen und mehreren Schaltungsanordnungszweigen mehrere geschaltete Signale mit verschiedenen Phasen zuzuführen, wobei eine Phase jedes der den Schaltungsanordnungszweigen zugeführten geschalteten Signale durch eine Konfiguration des Schaltnetzwerks bestimmt wird, wobei das Schaltnetzwerk Folgendes umfasst:
ein Schaltmodul (512), wobei das Schaltmodul dafür ausgelegt ist, das Eingangssignal zu empfangen, und mehrere mögliche Konfigurationen aufweist, die dafür ausgelegt sind, das Eingangssignal jeweils einem anderen von mehreren Ausgangsanschlüssen (514A, 514B) des Schaltmoduls zuzuführen, wobei die Konfiguration des Schaltnetzwerks durch die Konfiguration des Schaltmoduls definiert wird und wobei eine Anzahl von Schaltungsanordnungszweigen einer Anzahl möglicher Konfigurationen des Schaltmoduls entspricht,
eine zwischen der Schaltkomponente und einer Aufteilungskomponente (516) angeordnete Dämpfungsschaltungsanordnung (515A, 515B), wobei die Dämpfungsschaltungsanordnung dafür ausgelegt ist, ein von dem Schaltmodul ausgegebenes Signal gemäß der Konfiguration des Schaltmoduls zu dämpfen, und
wobei die Aufteilungskomponente (516) dafür ausgelegt ist, das von dem Schaltmodul ausgegebene Signal in zwei gleiche Signale mit einer definierten Phasendifferenz zwischen ihnen aufzuteilen, und wobei die zwei gleichen Signale den mehreren geschalteten Signalen entsprechen;
eine in jedem der mehreren Schaltungsanordnungszweige angeordnete Aufteilungsschaltungsanordnung (520A, 520B), die dafür ausgelegt ist, ein jeweiliges geschaltetes Signal zu empfangen und mehrere aufgeteilte Signale auf dem jeweiligen Schaltungsanordnungszweig bereitzustellen;
eine in jedem der mehreren Schaltungsanordnungszweige angeordnete Verstärkungsschaltungsanordnung (530A, 530B, 530C, 530D), die dafür ausgelegt ist, die mehreren geteilten Signale auf dem jeweiligen Schaltungsanordnungszweig zu empfangen, wobei die Verstärkungsschaltungsanordnung dafür ausgelegt ist, die mehreren aufgeteilten Signale zu verstärken, um mehrere verstärkte Signale bereitzustellen;
eine Kombinierschaltungsanordnung (540A, 540B, 540C), die dafür ausgelegt ist, die mehreren verstärkten Signale von jedem der mehreren Schaltungsanordnungszweige zu empfangen und einem der mehreren Ausgangsanschlüsse (550A, 550B) ein einzelnes Ausgangssignal zuzuführen, wobei eine Anzahl von Ausgangsanschlüssen der Anzahl möglicher Konfigurationen des Schaltmoduls entspricht und wobei das einzelne Ausgangssignal gemäß der Konfiguration des Schaltmoduls einem bestimmten der mehreren Ausgangsanschlüsse zugeführt wird.

2. Schaltungsanordnung nach Anspruch 1, wobei das Schaltmodul (512) Folgendes ist:
ein einpoliger Umschalter bzw. SPDT-Schalter mit zwei möglichen Konfigurationen und
wobei die Aufteilungskomponente (516) ein Gabelkoppler ist, wobei der SPDT-Schalter dafür ausgelegt ist, dem Gabelkoppler ein einziges Signal zuzuführen, und wobei der Gabelkoppler dafür ausgelegt ist, gemäß der Konfiguration des SPDT-Schalters entweder einem ersten oder einem zweiten Schaltungsanordnungszweig der mehreren Schaltungsanordnungszweige ein gleichphasiges Signal bereitzustellen und dem anderen des ersten oder des zweiten Schaltungsanordnungszweigs ein Quadratursignal bereitzustellen;
wobei die mehreren Ausgangsanschlüsse zwei Ausgangsanschlüsse umfassen.

3. Schaltungsanordnung nach Anspruch 1 oder Anspruch 2, wobei die Dämpfungsschaltungsanordnung mehrere Dämpfungsglieder umfasst, die jeweils einem jeweiligen Schaltungsanordnungszweig der mehreren Schaltungsanordnungzweige entsprechen, wobei ein Dämpfungspegel der mehreren Dämpfungsglieder gemäß der Konfiguration des Schaltnetzwerks eingestellt wird, um Signale auf einem oder mehreren ersten Schaltungsanordnungszweigen maximal zu dämpfen und ein zweites Schaltungsanordnungszweigsignal minimal zu dämpfen.

4. Schaltungsanordnung nach Anspruch 3, wobei der Dämpfungspegel der mehreren Dämpfungsglieder durch ein oder mehrere Steuersignale gesteuert wird, die auch dafür ausgelegt sind, die Konfiguration des Schaltnetzwerks zu steuern.

5. Schaltungsanordnung nach einem der vorhergehenden Ansprüche, wobei die Aufteilungsschaltungsanordnung mehrere Aufteilungskomponenten umfasst, die jeweils dafür ausgelegt sind, ein Eingangssignal in zwei Signale aufzuteilen, wobei jeder Schaltungsanordnungszweig eine oder mehrere Aufteilungskomponenten umfasst, die dafür ausgelegt sind, ein jeweiliges geschaltetes Signal von dem Schaltnetzwerk zu empfangen und die mehreren Aufteilungssignale der Verstärkungsschaltungsanordnung zuzuführen.

6. Schaltungsanordnung nach einem der vorhergehenden Ansprüche, wobei die Kombinierschaltungsanordnung mehrere Kombinierkomponenten umfasst, die jeweils dafür ausgelegt sind, zwei Eingangssignale zu einem einzigen Ausgangssignal zu kombinieren, wobei eine erste Kombinierkomponente dafür ausgelegt ist, verstärkte Signale zu kombinieren, die auf mehreren Pfaden eines ersten Schaltungsanordnungszweigs empfangen werden, wobei eine zweite Kombinierkomponente dafür ausgelegt ist, verstärkte Signale zu kombinieren, die auf mehreren Pfaden eines zweiten Schaltungsanordnungszweigs empfangen werden, und wobei eine dritte Kombinierkomponente dafür ausgelegt ist, Ausgangssignale des ersten und des zweiten Schaltungsanordnungszweigs zu kombinieren.

7. Schaltungsanordnung nach Anspruch 5 oder Anspruch 6, die ferner eine oder mehrere einer mit einem oder mehreren Ports der mehreren Aufteilungskomponenten und/oder Kombinierkomponenten verbundene Erfassungsschaltungsanordnung, Steuerschaltungsanordnung, Kompensationsschaltungsanordnung und/oder Kalibrierungsschaltungsanordnung umfasst.

8. Schaltungsanordnung nach einem der vorhergehenden Ansprüche, wobei jeder der mehreren Schaltungsanordnungszweige zwei oder mehr Pfade umfasst, wobei jeder der zwei oder mehr Pfade dafür ausgelegt ist, ein bestimmtes der mehreren aufgeteilten Signale zu empfangen, und jeder der zwei oder mehr Pfade die Verstärkungsschaltungsanordnung umfasst.

9. Schaltungsanordnung nach Anspruch 8, wobei jeder der mehreren Schaltungsanordnungszweige eine oder mehrere verschachtelte Schaltungsanordnungsketten umfasst, wobei die zwei oder mehr Pfade jeweils eine zusätzliche Aufteilungsschaltungsanordnung umfassen, die jeweils dafür ausgelegt sind, den jeweiligen Pfad in zwei oder mehr Unterpfade aufzuteilen, wobei jeder der zwei oder mehr Unterpfade die Verstärkungsschaltungsanordnung umfasst und wobei jeder der zwei Pfade eine zusätzliche Kombinierschaltungsanordnung umfasst, die dafür ausgelegt ist, auf den Unterpfaden des jeweiligen Pfades empfangene Signale zu kombinieren.

10. Schaltungsanordnung nach einem der vorhergehenden Anspruch, ferner umfassend:
eine zweite Verstärkungsschaltungsanordnung (511), die dafür ausgelegt ist, dem Schaltnetzwerk ein verstärktes einzelnes Eingangssignal zuzuführen.

11. Schaltungsanordnung nach einem der vorhergehenden Anspruch, ferner umfassend:
eine auf jedem der mehreren Schaltungsanordnungszweige zwischen dem Schaltnetzwerk und der Aufteilungsschaltungsanordnung angeordnete dritte Verstärkungsschaltungsanordnung (518A, 518B).

12. Schaltungsanordnung nach einem der vorhergehenden Ansprüche, wobei das Schaltnetzwerk, die Aufteilungs- und die Kombinierschaltungsanordnung dafür ausgelegt ist, eine elektrische Phase und Amplitude von Signalen auf jedem der mehreren Schaltungsanordnungszweige an den mehreren Ausgangsanschlüssen auszurichten.

13. Schaltungsanordnung nach einem der vorhergehenden Ansprüche, wobei die Schaltungsanordnung eine monolithische integrierte Schaltung ist.

## Revendications

1. Circuiterie (700) pour un amplificateur de puissance multivoie à entrée unique et sorties multiples, la circuiterie comprenant :
une circuiterie de commutation (510) configurée pour recevoir un signal d'entrée unique et fournir une pluralité de signaux commutés présentant des phases différentes à une pluralité de branches de circuiterie, une phase de chacun des signaux commutés fournis aux branches de circuiterie étant déterminée par une configuration de la circuiterie de commutation, la circuiterie de commutation comprenant :
un module de commutation (512), le module de commutation étant configuré pour recevoir le signal d'entrée et présentant une pluralité de configurations possibles agencées chacune de manière à fournir le signal d'entrée à une borne de sortie différente parmi une pluralité de bornes de sortie (514A, 514B) du module de commutation,
la configuration de la circuiterie de commutation étant définie par la configuration du module de commutation,
et un nombre de branches de circuiterie correspondant à un nombre de configurations possibles du module de commutation,
une circuiterie d'atténuation (515A, 515B) agencée entre le composant de commutation et un composant de division (516), la circuiterie d'atténuation étant configurée pour atténuer un signal délivré par le module de commutation, selon la configuration du module de commutation, et
le composant de division (516) étant agencé de manière à diviser le signal délivré par le module de commutation en deux signaux égaux présentant une différence de phase définie entre eux et les deux signaux égaux correspondant à la pluralité de signaux commutés ;
une circuiterie de division (520A, 520B) agencée dans chacune de la pluralité de branches de circuiterie et configurée pour recevoir un signal commuté respectif et fournir une pluralité de signaux divisés sur la branche de circuiterie respective ;
une circuiterie d'amplification (530A, 530B, 530C, 530D) agencée dans chacune de la pluralité de branches de circuiterie et configurée pour recevoir la pluralité de signaux divisés sur la branche de circuiterie respective,
la circuiterie d'amplification étant configurée pour amplifier la pluralité de signaux divisés afin de fournir une pluralité de signaux amplifiés ;
une circuiterie de combinaison (540A, 540B, 540C) configurée pour recevoir la pluralité de signaux amplifiés depuis chacune de la pluralité de branches de circuiterie et fournir un signal de sortie unique à une borne de sortie parmi une pluralité de bornes de sortie (550A, 550B), un nombre de bornes de sortie correspondant au nombre de configurations possibles du module de commutation, et le signal de sortie unique étant fourni à une borne de sortie particulière parmi la pluralité de bornes de sortie selon la configuration du module de commutation.

2. Circuiterie selon la revendication 1, dans laquelle le module de commutation (512) est :
un interrupteur unipolaire inverseur, SPDT, présentant deux configurations possibles, et
dans laquelle le composant de division (516) est un coupleur hybride, l'interrupteur SPDT étant configuré pour fournir un signal unique au coupleur hybride, et le coupleur hybride étant configuré pour fournir un signal en phase soit à une première soit à une deuxième branche de circuiterie parmi la pluralité de branches de circuiterie et fournir un signal en quadrature à l'autre de la première ou de la deuxième branche de circuiterie selon la configuration de l'interrupteur SPDT ;
dans laquelle la pluralité de bornes de sortie comprend deux bornes de sortie.

3. Circuiterie selon la revendication 1 ou la revendication 2, dans laquelle la circuiterie d'atténuation comprend une pluralité d'atténuateurs correspondant chacun à une branche de circuiterie respective de la pluralité de branches de circuiterie, un niveau d'atténuation de la pluralité d'atténuateurs étant défini selon la configuration de la circuiterie de commutation afin d'atténuer au maximum les signaux sur une ou plusieurs premières branches de circuiterie et d'atténuer au minimum un signal de deuxième branche de circuiterie.

4. Circuiterie selon la revendication 3, dans laquelle le niveau d'atténuation de la pluralité d'atténuateurs est commandé par un ou plusieurs signaux de commande également configurés pour commander la configuration de la circuiterie de commutation.

5. Circuiterie selon l'une quelconque des revendications précédentes, dans laquelle la circuiterie de division comporte une pluralité de composants de division configurés chacun pour diviser un signal d'entrée en deux signaux, chaque branche de circuiterie comportant un ou plusieurs composants de division configurés pour recevoir un signal commuté respectif depuis la circuiterie de commutation et fournir la pluralité de signaux divisés à la circuiterie d'amplification.

6. Circuiterie selon l'une quelconque des revendications précédentes, dans laquelle la circuiterie de combinaison comporte une pluralité de composants de combinaison configurés chacun pour combiner deux signaux d'entrée en un signal de sortie unique, un premier composant de combinaison étant configuré pour combiner des signaux amplifiés reçus sur des voies multiples d'une première branche de circuiterie, un deuxième composant de combinaison étant configuré pour combiner des signaux amplifiés reçus sur des voies multiples d'une deuxième branche de circuiterie, et un troisième composant de combinaison étant configuré pour combiner les sorties des première et deuxième branches de circuiterie.

7. Circuiterie selon la revendication 5 ou la revendication 6, comprenant en outre une circuiterie de détection et/ou une circuiterie de commande et/ou une circuiterie de compensation et/ou une circuiterie d'étalonnage, connectées à un ou plusieurs ports de la pluralité de composants de division et/ou de composants de combinaison.

8. Circuiterie selon l'une quelconque des revendications précédentes, dans laquelle chacune de la pluralité de branches de circuiterie comporte au moins deux voies, chacune des au moins deux voies étant configurée pour recevoir un signal divisé particulier parmi la pluralité de signaux divisés et chacune des au moins deux voies comportant la circuiterie d'amplification.

9. Circuiterie selon la revendication 8, dans laquelle chacune de la pluralité de branches de circuiterie comporte une ou plusieurs chaînes de circuiterie imbriquées, moyennant quoi les au moins deux voies comportent chacune une circuiterie de division supplémentaire configurée pour diviser la voie respective en au moins deux sous-voies, chacune des au moins deux sous-voies comportant la circuiterie d'amplification, et chacune des deux voies comportant une circuiterie de combinaison supplémentaire configurée pour combiner les signaux reçus sur les sous-voies de la voie respective.

10. Circuiterie selon l'une quelconque des revendications précédentes, comprenant en outre :
une deuxième circuiterie d'amplification (511) agencée de manière à fournir un signal d'entrée unique amplifié à la circuiterie de commutation.

11. Circuiterie selon l'une quelconque des revendications précédentes, comprenant en outre :
une troisième circuiterie d'amplification (518A, 518B) agencée sur chacune de la pluralité de branches de circuiterie entre la circuiterie de commutation et la circuiterie de division.

12. Circuiterie selon l'une quelconque des revendications précédentes, dans laquelle les circuiteries de commutation, de division et de combinaison sont agencées de manière à aligner une phase et une amplitude électriques des signaux sur chacune de la pluralité de branches de circuiterie au niveau de la pluralité de bornes de sortie.

13. Circuiterie selon l'une quelconque des revendications précédentes, la circuiterie constituant un circuit intégré monolithique.
